# EUROPEAN PATENT APPLICATION

(11) **EP 4 598 329 A1**
(43) Date of publication of application: **06.08.2025**
(21) Application number: 22960863.3
(22) Date of filing: 28.09.2022
(51) Int. Cl.: H10N 60/01

(54) **METHOD FOR PRODUCING JOSEPHSON JUNCTION ELEMENT AND METHOD FOR PRODUCING QUANTUM BIT DEVICE**

(71) Applicant: FUJITSU LIMITED, Kawasaki-shi, Kanagawa 211-8588 (JP)
(72) Inventor: TAKENOUCHI, Masatoshi, Kawasaki-shi, Kanagawa 211-8588 (JP); KOUMA, Norinao, Kawasaki-shi, Kanagawa 211-8588 (JP); HIROSE, Shinichi, Kawasaki-shi, Kanagawa 211-8588 (JP); TAKAHASHI, Tsuyoshi, Kawasaki-shi, Kanagawa 211-8588 (JP)
(74) Representative: Hoffmann Eitle
(86) International application number: PCT/JP2022/036204
(87) International publication number: WO 2024/069800

(57) **Abstract**

A method for manufacturing a Josephson junction device includes a process of forming a mask layer, on a substrate, that includes a first mask pattern that includes a first opening that extends in a first direction and a second opening that extends in a second direction intersecting with the first direction and a second mask pattern that includes a third opening that is shorter than the second opening in the first direction and is shorter than the first opening in the second direction, a process of forming a first superconducting film on the substrate in the first mask pattern, by first film formation from obliquely above the substrate, as using the mask layer as a mask, a process of forming an insulating film on a surface of the first superconducting film, a process of forming a second superconducting film that has a region that overlaps the first superconducting film via the insulating film in the first mask pattern, by second film formation from obliquely above the substrate, as using the mask layer as a mask, and a process of removing the mask layer by lift-off.

## Description

### TECHNICAL FIELD

The present invention relates to a method for manufacturing a Josephson junction device and a method for manufacturing a quantum bit device.

### BACKGROUND ART

Development of a superconducting quantum computer including a quantum bit device has been proceeded. As the quantum bit device, a configuration has been known that includes a qubit in which a Josephson junction device is coupled to a capacitor in parallel. The Josephson junction device has a structure in which an insulating film is sandwiched between two layers of superconducting films. As a method for manufacturing the Josephson junction device, a method for forming a superconducting film by oblique vapor deposition using a mask layer, and then, removing the mask layer by lift-off has been known (for example, Patent Documents 1 and 2). Furthermore, it has been known to use a mask layer having an opening for inflow of a peeling solution used for lift-off in addition to an opening for forming a target pattern, in order to shorten a lift-off processing time (for example, Patent Document 3). Furthermore, it has been known that, in a field effect transistor, oblique vapor deposition is performed using a mask layer having openings with different sizes as a mask and a gate electrode is formed only in the larger opening (for example, Patent Document 4).

### CITATION LIST

### PATENT DOCUMENT

Patent Document 1: Japanese National Publication of International Patent Application No. 2020-535461
Patent Document 2: U.S. Patent Application Publication No. 2021/0130944
Patent Document 3: Japanese Laid-open Patent Publication No. 2016-39177
Patent Document 4: Japanese Laid-open Patent Publication No. 2004-281926

### SUMMARY OF INVENTION

### TECHNICAL PROBLEM

A Josephson junction device used for a qubit is small in plan view. Therefore, in a case where a superconducting film of the Josephson junction device is formed by film formation from an oblique direction using a mask layer as a mask, an opening provided in the mask layer to form the superconducting film is smaller in plan view. Therefore, in a case where the mask layer is removed by lift-off, a route through which a peeling solution enters the mask layer is limited, and a peeling time of the mask layer is increased.

In Patent Document 3, to shorten the lift-off processing time, an inflow opening for allowing the peeling solution to inflow is provided in addition an opening for forming a target pattern in the mask layer. However, since an unnecessary metal film is formed at a portion where the inflow opening is provided, a formation position of the inflow opening is limited. Therefore, there is a room for improvement in terms of shortening the peeling time of the mask layer.

In one aspect, an object is to shorten a peeling time of a mask layer.

### SOLUTION TO PROBLEM

In one aspect, a method for manufacturing a Josephson junction device includes a process of forming a mask layer, on a substrate, that includes a first mask pattern that has a first opening that extends in a first direction and a second opening that extends in a second direction intersecting with the first direction and a second mask pattern that has a third opening that is shorter than the second opening in the first direction and is shorter than the first opening in the second direction, a process of forming a first superconducting film above the substrate in the first mask pattern, by first film formation from obliquely above the substrate, as using the mask layer as a mask, a process of forming an insulating film above a surface of the first superconducting film, a process of forming a second superconducting film that has a region that overlaps the first superconducting film via the insulating film in the first mask pattern, by second film formation from obliquely above the substrate, as using the mask layer as a mask, and a process of removing the mask layer by lift-off.

In one aspect, a method for manufacturing a quantum bit device includes a process of forming a Josephson junction device, a process of forming a capacitor coupled to the Josephson junction device in parallel, and a process of forming a resonator and a filter coupled to a qubit that includes the Josephson junction device and the capacitor, in which the process of forming the Josephson junction device includes a process of forming a mask layer, on a substrate, that includes a first mask pattern that has a first opening that extends in a first direction and a second opening that extends in a second direction intersecting with the first direction and a second mask pattern that has a third opening that is shorter than the second opening in the first direction and is shorter than the first opening in the second direction, a process of forming a first superconducting film above the substrate in the first mask pattern, by first film formation from obliquely above the substrate, as using the mask layer as a mask, a process of forming an insulating film above a surface of the first superconducting film, a process of forming a second superconducting film that has a region that overlaps the first superconducting film via the insulating film in the first mask pattern, by second film formation from obliquely above the substrate, as using the mask layer as a mask, and a process of removing the mask layer by lift-off.

### ADVANTAGEOUS EFFECTS OF INVENTION

As one aspect, it is possible to shorten a peeling time of a mask layer.

### BRIEF DESCRIPTION OF DRAWINGS

FIGs. 1A to 1C are diagrams (part 1) illustrating a method for manufacturing a Josephson junction device according to a first embodiment.
FIGs. 2A to 2C are diagrams (part 2) illustrating the method for manufacturing the Josephson junction device according to the first embodiment.
FIGs. 3A to 3C are diagrams (part 3) illustrating the method for manufacturing the Josephson junction device according to the first embodiment.
FIGs. 4A to 4C are diagrams (part 4) illustrating the method for manufacturing the Josephson junction device according to the first embodiment.
FIGs. 5A to 5C are diagrams (part 5) illustrating the method for manufacturing the Josephson junction device according to the first embodiment.
FIGs. 6A to 6D are diagrams (part 1) illustrating a method for manufacturing a Josephson junction device according to a comparative example.
FIGs. 7A to 7D are diagrams (part 2) illustrating the method for manufacturing the Josephson junction device according to the comparative example.
FIG. 8A is a plan view of a model used for a simulation, and FIG. 8B is a cross-sectional view taken along an A-A line in FIG. 8A.
FIG. 9 is a diagram illustrating a simulation result.
FIG. 10A is a cross-sectional view of a portion corresponding to C-C in FIG. 2A, and FIG. 10B is a cross-sectional view of a portion corresponding to C-C in FIG. 4A.
FIG. 11A is an enlarged plan view of vicinity of a mask pattern in FIG. 4A, FIG. 11B is a cross-sectional view taken along an A-A line in FIG. 11A, and FIG. 11C is a cross-sectional view taken along a B-B line in FIG. 11A.
FIGs. 12A and 12B are diagrams (part 1) illustrating a method for manufacturing a Josephson junction device according to a second embodiment.
FIGs. 13A and 13B are diagrams (part 2) illustrating the method for manufacturing the Josephson junction device according to the second embodiment.
FIGs. 14A and 14B are diagrams (part 3) illustrating the method for manufacturing the Josephson junction device according to the second embodiment.
FIGs. 15A and 15B are diagrams (part 4) illustrating the method for manufacturing the Josephson junction device according to the second embodiment.
FIGs. 16A and 16B are diagrams (part 5) illustrating the method for manufacturing the Josephson junction device according to the second embodiment.
FIG. 17A is an enlarged plan view of vicinity of a mask pattern in FIG. 15A, and FIG. 17B is a cross-sectional view taken along an A-A line in FIG. 17A.
FIG. 18A is a plan view of a quantum bit device according to a third embodiment, and FIG. 18B is an enlarged view of a qubit in FIG. 18A.
FIGs. 19A to 19D are cross-sectional views (part 1) illustrating a method for manufacturing the quantum bit device according to the third embodiment.
FIGs. 20A to 20C are cross-sectional views (part 2) illustrating the method for manufacturing the quantum bit device according to the third embodiment.
FIGs. 21A to 21C are cross-sectional views (part 3) illustrating the method for manufacturing the quantum bit device according to the third embodiment.

### DESCRIPTION OF EMBODIMENTS

Hereinafter, embodiments of the present invention will be described with reference to the drawings.

### [First Embodiment]

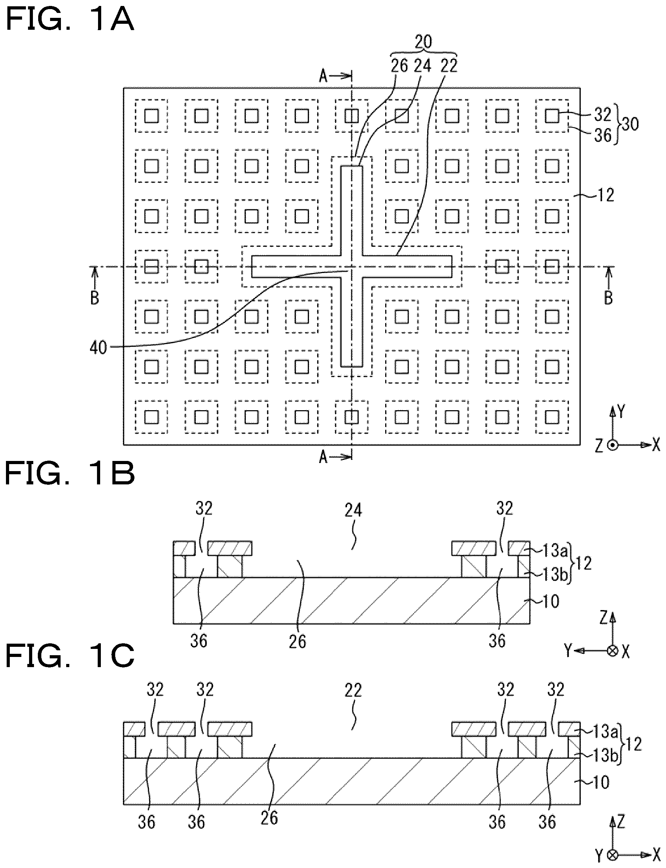

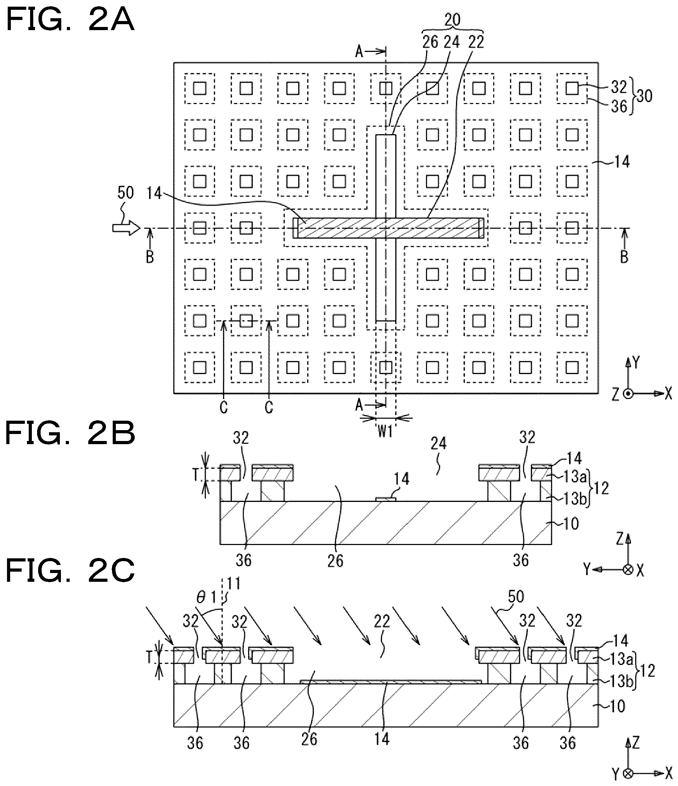

In a first embodiment, a method for manufacturing a Josephson junction device called a Manhattan type will be described. FIGs. 1A to 5C are diagrams illustrating the method for manufacturing the Josephson junction device according to the first embodiment. FIGs. 1A, 2A, 3A, 4A, and 5A are plan views illustrating the method for manufacturing the Josephson junction device according to the first embodiment. FIGs. 1B, 2B, 3B, 4B, and 5B are cross-sectional views taken along A-A lines in FIGs. 1A, 2A, 3A, 4A, and 5A. FIGs. 1C, 2C, 3C, 4C, and 5C are cross-sectional views taken along B-B lines in FIGs. 1A, 2A, 3A, 4A, and 5A. In FIGs. 2A, 3A, and 4A, in order to clarify the figures, a superconducting film 14, an insulating film 16, and a superconducting film 18 formed in a gap 26 are hatched (the same applies to following similar figures).

As in FIGs. 1A to 1C, a mask layer 12 is formed on a substrate 10. The substrate 10 is, for example, a high-resistance silicon substrate. The mask layer 12 is formed of, for example, a photoresist and includes an upper layer 13a and a lower layer 13b. A thickness of the upper layer 13a is, for example, thinner than a thickness of the lower layer 13b. As an example, the thickness of the upper layer 13a is 200 nm, and the thickness of the lower layer 13b is 800 nm. In the mask layer 12, a mask pattern 20 having an opening 22, an opening 24, and the gap 26 and a mask pattern 30 having an opening 32 and a gap 36 are formed.

In the mask pattern 20, the opening 22 extends in an X-axis direction, the opening 24 extends in a Y-axis direction intersecting with (for example, orthogonal to) the opening 22, and both openings are formed in the upper layer 13a. In this way, the mask pattern 20 has a cross-shaped opening formed by the openings 22 and 24 in the upper layer 13a. A width of the opening 22 (length in Y-axis direction) and a width of the opening 24 (length in X-axis direction) are, for example, substantially the same. The widths of the openings 22 and 24 are, for example, 100 nm to 300 nm, and are 200 nm, as an example. A length of the opening 22 (length in X-axis direction) and a length of the opening 24 (length in Y-axis direction) are, for example, substantially the same and are, for example, equal to or more than 1 µm. The gap 26 is formed in the lower layer 13b. The gap 26 is positioned below the openings 22 and 24, and has a larger shape than the openings 22 and 24 in plan view. For example, in the mask layer 12, the lower layer 13b is formed by using a photoresist having higher sensitivity to exposure (for example, electron beam exposure) to form the openings 22 and 24 and the gap 26 than the upper layer 13a. As a result, when the openings 22 and 24 are formed in the upper layer 13a, the gap 26 having a shape obtained by enlarging the shapes of the openings 22 and 24 is formed in the lower layer 13b.

In the mask pattern 30, the opening 32 is formed in the upper layer 13a in a shape smaller than a region 40 where the openings 22 and 24 of the mask pattern 20 intersect in plan view. That is, a length of the opening 32 in the X-axis direction is shorter than the length of the opening 24 in the X-axis direction, and a length of the opening 32 in the Y-axis direction is shorter than the length of the opening 22 in the Y-axis direction. The opening 32 has, for example, a rectangular shape in plan view, and the length in the X-axis direction and the length in the Y-axis direction are, for example, 150 nm. Note that the opening 32 may have another shape such as a circular shape or an elliptical shape in plan view. The gap 36 is formed in the lower layer 13b. The gap 36 is positioned below the opening 32 and has a larger shape than the opening 32 in plan view. By using the photoresist with higher sensitivity to the exposure than that of the upper layer 13a for the lower layer 13b, when the opening 32 is formed in the upper layer 13a, the gap 36 having a shape obtained by enlarging the shape of the opening 32 is formed in the lower layer 13b. The plurality of mask patterns 30 is formed around the mask pattern 20 to surround the mask pattern 20. The plurality of mask patterns 30 is arranged at substantially constant intervals between the adjacent mask patterns 30 without via the mask pattern 20 in the X-axis direction and the Y-axis direction, and for example, is provided in a lattice pattern. Note that the plurality of mask patterns 30 may be provided in a staggered manner.

As in FIGs. 2A to 2C, the superconducting film 14 is formed above the substrate 10 by film formation from obliquely above in a -X direction, as indicated by an arrow 50, using the mask layer 12 as a mask. For example, the superconducting film 14 is formed by an oblique vacuum deposition method. An incident angle θ1 of a film-forming material with respect to a normal line 11 of the substrate 10 is, for example, 30° to 60° and is 45° as an example. The superconducting film 14 is, for example, an aluminum (Al) film. Since the superconducting film 14 is formed by film formation from obliquely above in the -X direction, by setting the width of the opening 24 to an appropriate size, the formation of the superconducting film 14 extending in the Y-axis direction in the gap 26 is suppressed. The superconducting film 14 extending in the X-axis direction is formed in the gap 26. A thickness of the superconducting film 14 is, for example, 10 nm to 100 nm and is 30 nm as an example.

Here, suppression of the formation of the superconducting film 14 extending in the Y-axis direction in the gap 26 will be described. The incident angle of the film-forming material with respect to the normal line 11 of the substrate 10 is set to θ1, the thickness of the upper layer 13a of the mask layer 12 is set to T, and the width of the opening 24 is set to W1. In this case, the width of the opening 24 that satisfies a relationship of W1 ≤ T × tanθ1 is set. As a result, the film-forming material is less likely to enter the gap 26 via the opening 24, and the formation of the superconducting film 14 extending in the Y-axis direction in the gap 26 is suppressed.

Since the superconducting film 14 is formed by film formation from obliquely above in the -X direction, the superconducting film 14 is formed to be shifted in the +X direction with respect to the opening 22. Since the length of the opening 32 in the X-axis direction in the mask pattern 30 is shorter than the width W1 of the opening 24, the formation of the superconducting film 14 in the gap 36 is suppressed.

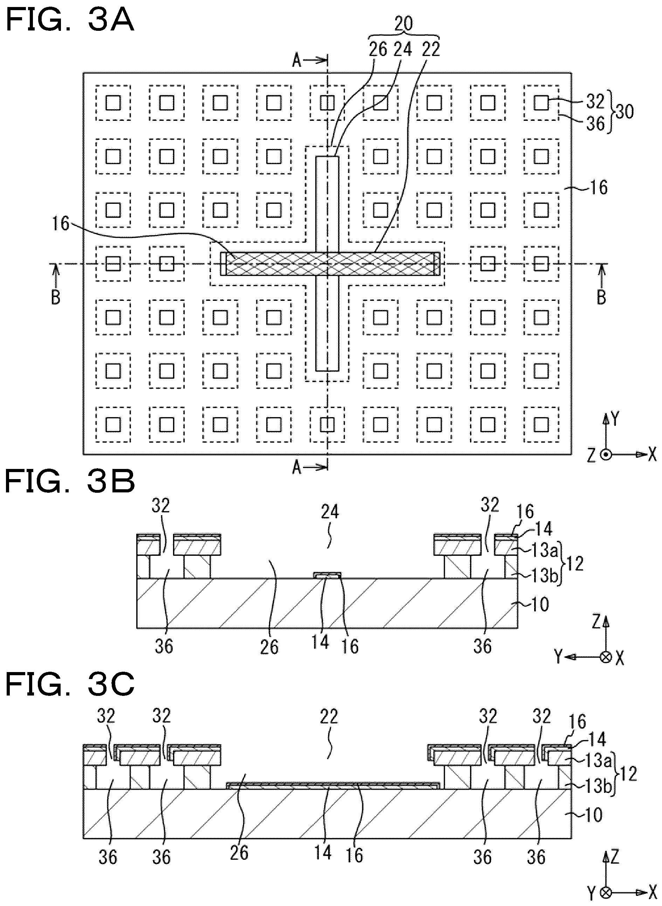

As in FIGs. 3A to 3C, while maintaining a vacuum state when the superconducting film 14 is formed, oxygen is introduced into a chamber to oxidize a surface of the superconducting film 14, and the insulating film 16 is formed at the surface of the superconducting film 14.

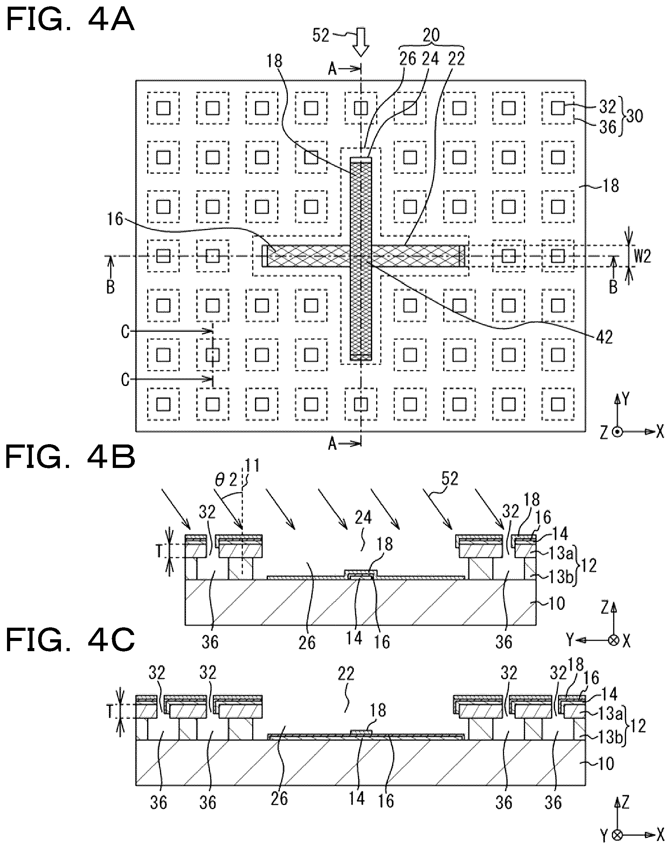

As in FIGs. 4A to 4C, the superconducting film 18 is formed above the substrate 10 by film formation from obliquely above in a +Y direction, as indicated by an arrow 52, using the mask layer 12 as a mask. For example, the superconducting film 18 is formed by the oblique vacuum deposition method. An incident angle θ2 of the film-forming material with respect to the normal line 11 of the substrate 10 is, for example, 30° to 60° and is 45° as an example. The superconducting film 18 is, for example, an aluminum (Al) film. Since the superconducting film 18 is formed by film formation from obliquely above in the +Y direction, by setting the width of the opening 22 to an appropriate size, formation of the superconducting film 18 extending in the X-axis direction in the gap 26 is suppressed. The superconducting film 18 extending in the Y-axis direction is formed in the gap 26. That is, as in a case of the superconducting film 14, in a case where the incident angle of the film-forming material with respect to the normal line 11 of the substrate 10 is set to θ2, the thickness of the upper layer 13a of the mask layer 12 is set to T, and the width of the opening 22 is set to W2, a relationship of W2 ≤ T × tanθ2 is satisfied. As a result, the film-forming material is less likely to enter the gap 26 via the opening 22, and the formation of the superconducting film 18 extending in the X-axis direction in the gap 26 is suppressed. A thickness of the superconducting film 18 is, for example, about 10 nm to 100 nm and is 40 nm as an example.

By forming the superconducting film 18 extending in the Y-axis direction in the gap 26, a region 42 is formed where the superconducting film 14 extending in the X-axis direction and the superconducting film 18 extending in the Y-axis direction overlap via the insulating film 16. Since the superconducting film 18 is formed by film formation from obliquely above in the +Y direction, the superconducting film 18 is formed to be shifted in a -Y direction with respect to the opening 24. Since the length of the opening 32 in the Y-axis direction in the mask pattern 30 is shorter than the width W2 of the opening 22, the formation of the superconducting film 18 in the gap 36 is suppressed.

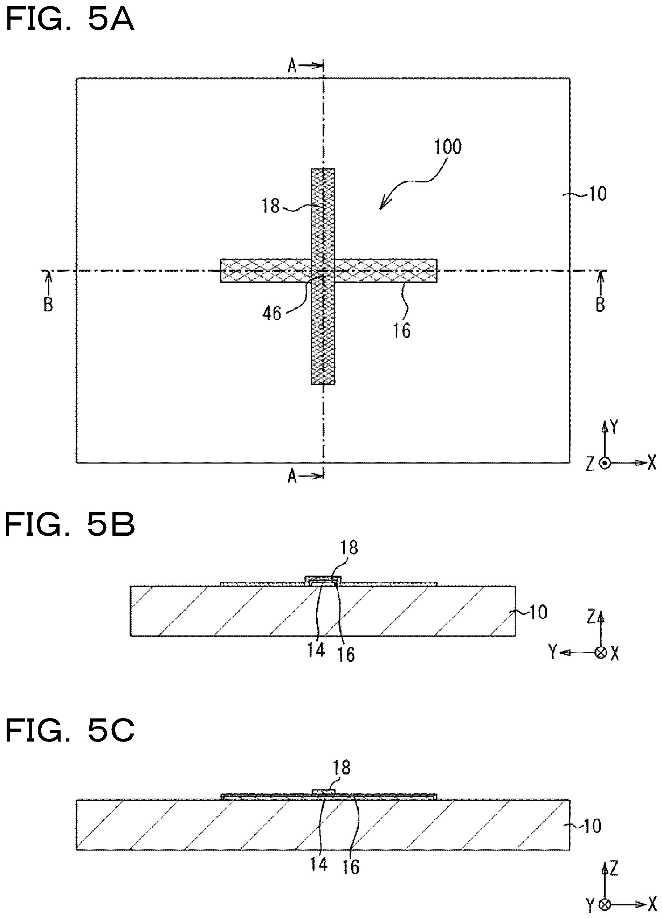

As in FIGs. 5A to 5C, the mask layer 12, and the superconducting film 14, the insulating film 16, and the superconducting film 18 formed above the mask layer 12 are removed by a lift-off method. In the mask layer 12, the openings 22 and 24 in the mask pattern 20 and the opening 32 in the mask pattern 30 are formed. Therefore, a peeling solution used for lift-off enters the mask layer 12 from the opening 32, in addition to the openings 22 and 24. The region where the superconducting film 14 extending in the X-axis direction and the superconducting film 18 extending in the Y-axis direction overlap via the insulating film 16 serves as a Josephson junction unit 46, and a Josephson junction device 100 is formed on the substrate 10. The insulating film 16 has the thickness with which a tunnel effect may be obtained at a temperature at which superconduction occurs.

### [Comparative Example]

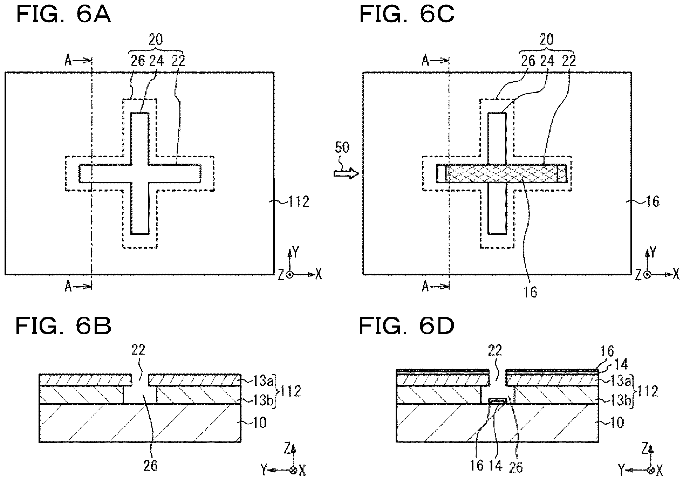

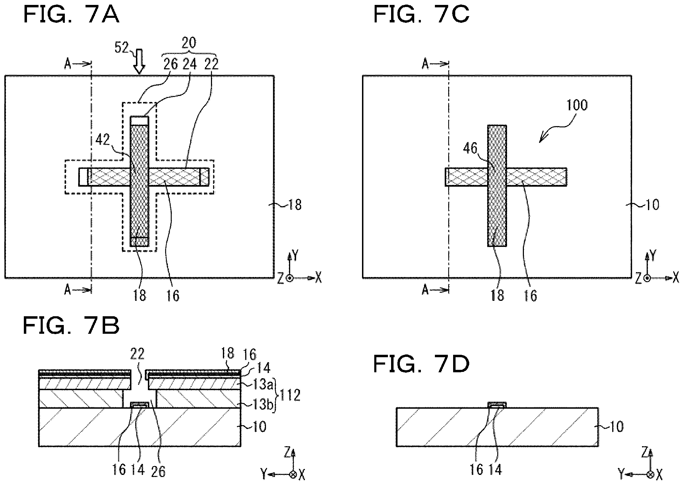

FIGs. 6A to 7D are diagrams illustrating a method for manufacturing a Josephson junction device according to a comparative example. FIGs. 6A, 6C, 7A, and 7C are plan views illustrating the method for manufacturing the Josephson junction device according to the comparative example. FIGs. 6B, 6D, 7B, and 7D are cross-sectional views of A-A lines in FIGs. 6A, 6C, 7A, and 7C. As in FIGs. 6A and 6B, a mask layer 112 is formed on a substrate 10. Although a mask pattern 20 is formed in the mask layer 112, a mask pattern 30 is not formed.

As in FIGs. 6C and 6D, a superconducting film 14 is formed above the substrate 10 by film formation from obliquely above in a -X direction, as indicated by an arrow 50, using the mask layer 112 as a mask. Thereafter, while maintaining a vacuum state when the superconducting film 14 is formed, oxygen is introduced into a chamber to oxidize a surface of the superconducting film 14, and an insulating film 16 is formed at the surface of the superconducting film 14.

As in FIGs. 7A and 7B, a superconducting film 18 is formed above the substrate 10 by film formation from obliquely above in a +Y direction, as indicated by an arrow 52, using the mask layer 112 as a mask. As a result, a region 42 is formed where the superconducting film 14 extending in an X-axis direction and the superconducting film 18 extending in a Y-axis direction overlap via the insulating film 16.

As in FIGs. 7C and 7D, the mask layer 112, and the superconducting film 14, the insulating film 16, and the superconducting film 18 formed above the mask layer 112 are removed by a lift-off method. Since the mask pattern 30 is not formed in the mask layer 112, a peeling solution used for lift-off enters only from openings 22 and 24 in the mask pattern 20. The region where the superconducting film 14 extending in the X-axis direction and the superconducting film 18 extending in the Y-axis direction overlap via the insulating film 16 serves as a Josephson junction unit 46, and a Josephson junction device 100 is formed on the substrate 10.

An example of manufacturing of the Josephson junction device 100 according to the comparative example is described. A thickness of an upper layer 13a of the mask layer 112 was set to 300 nm, and a thickness of a lower layer 13b was set to 800 nm. A width of the opening 22 and a width of the opening 24 formed in the mask layer 112 were set to 200 nm. The superconducting films 14 and 18 were formed by an oblique vacuum deposition method in which an incident angle of a deposition material with respect to a normal line of the substrate 10 is set to 40°, and a thickness was set to 40 nm. By performing lift-off using the peeling solution while heating the mask layer 112 to 80°C, the mask layer 112 was removed. At this time, a peeling time of the mask layer 112 by the lift-off was 120 minutes. In this way, in the comparative example, a lift-off processing time has been increased. When the lift-off processing time increases, manufacturing cost increases. Furthermore, an adverse effect on characteristics caused by immersion of the Josephson junction device in the peeling solution for a long time is also concerned.

On the other hand, in the first embodiment, the peeling solution used for the lift-off enters the mask layer 12 from the opening 32 of the mask pattern 30, in addition to the openings 22 and 24 of the mask pattern 20. Therefore, in the first embodiment, the lift-off processing time is shortened, and the increase in the manufacturing cost can be suppressed, as compared with the comparative example.

### [Simulation]

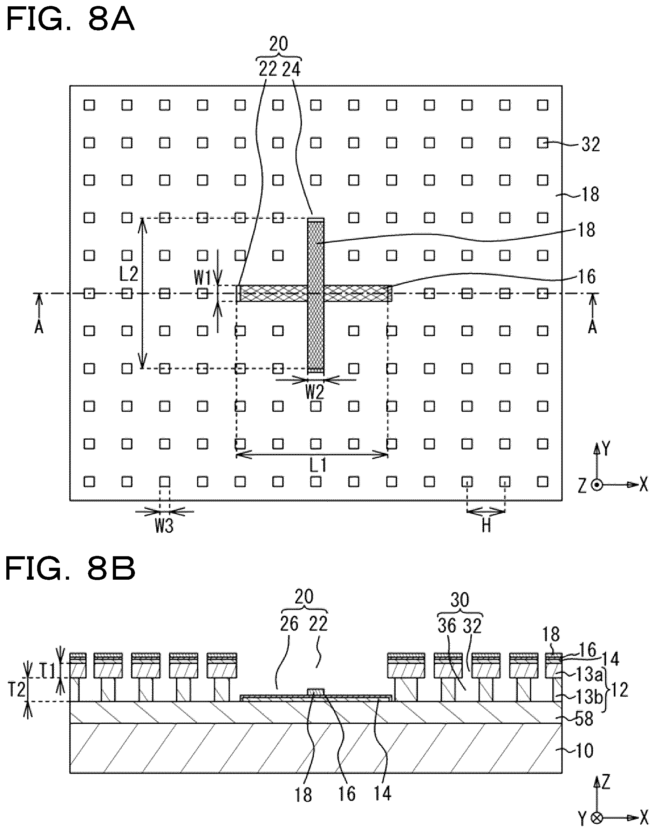

A simulation for investigating a correlation between an interval of the openings 32 of the mask pattern 30 and a peeling time depending on an exposure time of the mask layer 12 and the lift-off of the mask layer 12 was performed. FIG. 8A is a plan view of a model used for the simulation, and FIG. 8B is a cross-sectional view taken along an A-A line in FIG. 8A. In FIG. 8A, in order to clarify the figures, illustration of the gaps 26 and 36 is omitted, and the insulating film 16 and the superconducting film 18 formed in the gap 26 are hatched.

As in FIGs. 8A and 8B, in the model used for the simulation, it was assumed that a metal film 58 that is a titanium nitride film be provided between the substrate 10 and the mask layer 12. It was assumed that the mask layer 12 have a configuration including the mask pattern 20 having the openings 22 and 24 and the gap 26 and the plurality of mask patterns 30 provided around the mask pattern 20 and having the opening 32 having a square shape in plan view and the gap 36. It was assumed that the openings 32 in the plurality of mask patterns 30 be arranged and provided in a lattice pattern. A thickness T1 of the upper layer 13a of the mask layer 12 was set to 200 nm, and a thickness T2 of the lower layer 13b was set to 800 nm. A width W1 of the opening 22 of the mask pattern 20 and a width W2 of the opening 24 were set to 250 nm, and a length L1 of the opening 22 and a length L2 of the opening 24 were set to 2500 nm. A width W3 of the opening 32 of the mask pattern 30 was set to 100 nm. In this case, an exposure time required to form the mask patterns 20 and 30 in the mask layer 12 and a peeling time required to remove the mask layer 12 by the lift-off, when an interval H between the adjacent openings 32 is changed, were simulated.

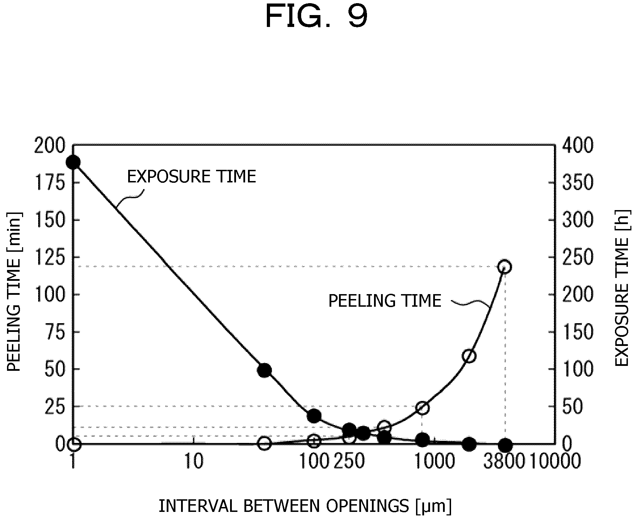

FIG. 9 is a diagram illustrating a simulation result. A horizontal axis in FIG. 9 indicates the interval H [µm] between the adjacent openings 32. A left-side vertical axis indicates a peeling time [min] required to remove the mask layer 12, and a peeling time when the interval H between the openings 32 is 1 µm is set as a reference. The right-side vertical axis represents an exposure time [h] required to form the mask patterns 20 and 30 in the mask layer 12, and the exposure time when the interval H between the openings 32 is 3800 µm is set as a reference.

As in FIG. 9, the peeling time of the mask layer 12 when the interval H between the openings 32 is 3800 µm was about 120 min. As the interval H between the openings 32 decreases and the number of openings 32 increases, the peeling time of the mask layer 12 was shortened. For example, in a case where the interval H between the openings 32 is 800 µm, the peeling time of the mask layer 12 was about 25 min that is about 1/5 of that when the interval H between the openings 32 is 3800 µm. In a case where the interval H between the openings 32 is 400 µm, the peeling time of the mask layer 12 was about 12 min that is about 1/10 of that when the interval H between the openings 32 is 3800 µm. In a case where the interval H between the openings 32 is 250 µm, the peeling time of the mask layer 12 was about 8 min that is about 1/15 of that when the interval H between the openings 32 is 3800 µm. This is because the mask layer 12 is easily removed because the peeling solution used for the lift-off enters more openings 32, as the interval H between the openings 32 decreases. On the other hand, as the interval H between the openings 32 decreases and the number of openings 32 increases, the exposure time of electron beam exposure was increased. In this way, with respect to the interval H between the openings 32, the peeling time and the exposure time have a trade-off relationship. However, it is found that the peeling time can be shortened while suppressing the increase in the exposure time, by setting the interval H between the openings 32 to an appropriate size (for example, equal to or more than 100 µm and equal to or less than 1000 µm).

As described above, according to the first embodiment, as in FIGs. 1A to 1C, the mask layer 12 including the mask pattern 20 (first mask pattern) and the mask pattern 30 (second mask pattern) is formed on the substrate 10. The mask pattern 20 has the opening 22 (first opening) extending in the X-axis direction and the opening 24 (second opening) extending in the Y-axis direction. The mask pattern 30 has the opening 32 shorter than the opening 22 in the Y-axis direction and shorter than the opening 24 in the X-axis direction. As in FIGs. 2A to 2C, by using the mask layer 12 as a mask and forming the film from obliquely above in the -X direction (first obliquely above direction) (first film formation), the superconducting film 14 is formed above the substrate 10 in the mask pattern 20. As in FIGs. 3A to 3C, the insulating film 16 is formed on the surface of the superconducting film 14. As in FIGs. 4A to 4C, by using the mask layer 12 as a mask and forming the film from obliquely above in the +Y direction (second obliquely above direction) (second film formation), the superconducting film 18 is formed in the mask pattern 20. The superconducting film 18 is formed to have the region 42 overlapping the superconducting film 14 via the insulating film 16. As in FIGs. 5A to 5C, the mask layer 12 is removed by the lift-off. In this way, since the opening 32 is shorter than the opening 22 in the Y-axis direction and is shorter than the opening 24 in the X-axis direction, the formation of the superconducting films 14 and 18 above the substrate 10 in the mask pattern 30 is suppressed. Therefore, a degree of freedom of a formation position of the mask pattern 30 increases, and it is possible to form the mask pattern 30 at a desired position. Since the peeling solution used for the lift-off enters the mask layer 12 from the opening 32 of the mask pattern 30 in addition to the openings 22 and 24 of the mask pattern 20, the peeling time of the mask layer 12 can be shortened.

Furthermore, in the first embodiment, as in FIGs. 2A to 2C, the superconducting film 14 is not formed above the substrate 10 in the mask pattern 30. As in FIGs. 4A to 4C, the superconducting film 18 is not formed above the substrate 10 in the mask pattern 30. As a result, a degree of freedom of a formation position of the mask pattern 30 increases.

Furthermore, in the first embodiment, as in FIG. 1A, the plurality of mask patterns 30 is provided around the mask pattern 20. Since the formation of the superconducting films 14 and 18 above the substrate 10 in the mask pattern 30 is suppressed, the plurality of mask patterns 30 can be provided around the mask pattern 20. As a result, the peeling solution used for the lift-off enters the mask layer 12 from the openings 32 of the plurality of mask patterns 30, and the peeling time of the mask layer 12 can be shortened.

Furthermore, in the first embodiment, as in FIG. 1A, the plurality of mask patterns 30 is provided so that the adjacent mask patterns 30 among the plurality of mask patterns 30 are arranged at a constant interval in the X-axis direction and the Y-axis direction without via the mask pattern 20. As a result, since the peeling solution used for the lift-off enters from the opening 32 across a wide range of the mask layer 12 without uneven distribution to a part of the mask layer 12, the peeling time of the mask layer 12 can be shortened. The plurality of mask patterns 30 may be arranged in a lattice pattern or may be arranged in a staggered pattern, for example.

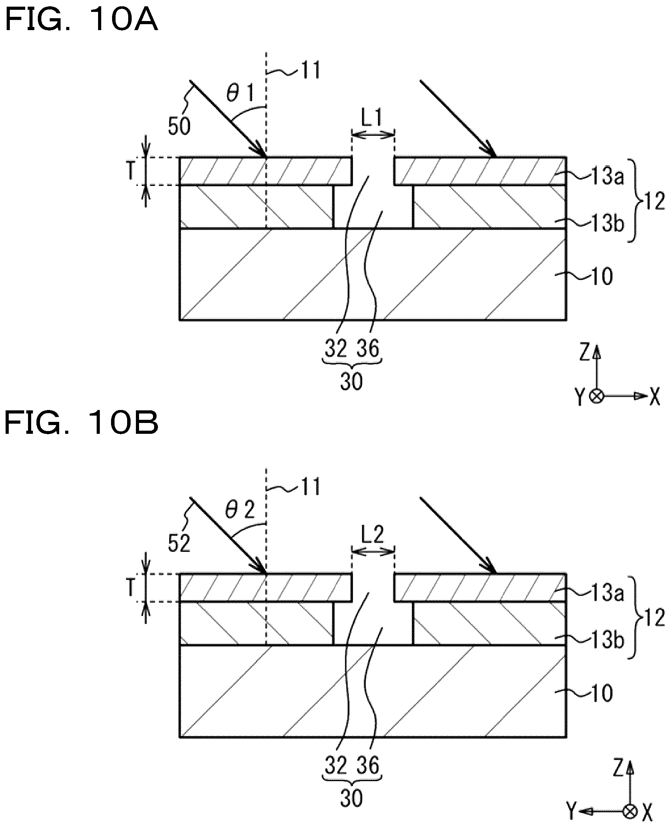

FIG. 10A is a cross-sectional view of a portion corresponding to C-C in FIG. 2A, and FIG. 10B is a cross-sectional view of a portion corresponding to C-C in FIG. 4A. As illustrated in FIG. 10A, in the formation of the superconducting film 14, the incident angle of the film-forming material with respect to the normal line 11 of the substrate 10 in the film formation from obliquely above in the -X direction is set to θ1. The thickness of the upper layer 13a of the mask layer 12 is set to T. The length of the opening 32 in the X-axis direction that is a direction corresponding to obliquely above in the -X direction is set to L1. In this case, it is preferable that L1 ≤ T × tanθ1 be satisfied. As a result, the formation of the superconducting film 14 above the substrate 10 in the mask pattern 30 is suppressed. From the viewpoint of suppressing the formation of the superconducting film 14 above the substrate 10 in the mask pattern 30, a case where L1 ≤ 0.9 × (T × tanθ1) is satisfied is preferable, and a case where L1 ≤ 0.8 × (T × tanθ1) is satisfied is more preferable.

As illustrated in FIG. 10B, in the formation of the superconducting film 18, the incident angle of the film-forming material with respect to the normal line 11 of the substrate 10 in the film formation from obliquely above in the +Y direction is set to θ2. The thickness of the upper layer 13a of the mask layer 12 is set to T. The length of the opening 32 in the Y-axis direction that is a direction corresponding to obliquely above in the +Y direction is set to L2. In this case, a case where L2 ≤ T × tanθ2 is satisfied is preferable. As a result, the formation of the superconducting film 18 above the substrate 10 in the mask pattern 30 is suppressed. From the viewpoint of suppressing the formation of the superconducting film 18 above the substrate 10 in the mask pattern 30, a case where L2 ≤ 0.9 × (T × tanθ2) is satisfied is preferable, and a case where L2 ≤ 0.8 × (T × tanθ2) is satisfied is more preferable.

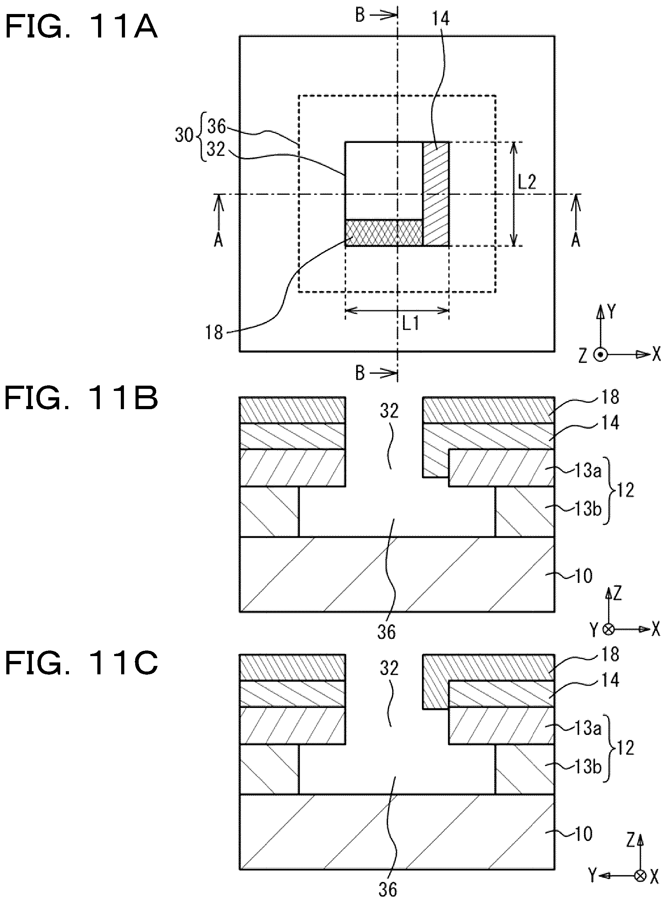

FIG. 11A is an enlarged plan view of vicinity of the mask pattern 30 in FIG. 4A, FIG. 11B is a cross-sectional view taken along an A-A line in FIG. 11A, and FIG. 11C is a cross-sectional view taken along a B-B line in FIG. 11A. Note that, in FIGs. 11A to 11C, since the insulating film 16 very thinner than the superconducting films 14 and 18, illustration is omitted here. As in FIGs. 11A to 11C, the superconducting film 14 is formed by film formation from obliquely above in the -X direction, and the superconducting film 18 is formed by film formation from obliquely above in the +Y direction. Therefore, the superconducting films 14 and 18 are formed on side surfaces of the opening 32. Therefore, the length L1 of the opening 32 in the X-axis direction is set to be larger than the thickness of the superconducting film 14, and the length L2 of the opening 32 in the Y-axis direction is set to be larger than the thickness of the superconducting film 18, so that the peeling solution used for the lift-off can enter the mask layer 12 from the opening 32. From the viewpoint of causing the peeling solution to enter the mask layer 12 from the opening 32, the length L1 of the opening 32 in the X-axis direction is preferably equal to or more than 1.5 times of the thickness of the superconducting film 14 and is more preferably equal to or more than 1.8 times, and still more preferably equal to or more than 2.0 times. Similarly, the length L2 of the opening 32 in the Y-axis direction is preferably equal to or more than 1.5 times of the thickness of the superconducting film 18, more preferably equal to or more than 1.8 times, and still more preferably equal to or more than 2.0 times.

Furthermore, in the first embodiment, as in FIG. 1A, the mask layer 12 including the mask pattern 20 in which the opening 22 extending in the X-axis direction and the opening 24 extending in the Y-axis direction intersect is formed. As in FIG. 2A, by the film formation from obliquely above in the -X direction, the superconducting film 14 is formed above the substrate 10 in the mask pattern 20. As in FIG. 4A, the superconducting film 18 is formed above the substrate 10 in the mask pattern 20, by the film formation from obliquely above in the +Y direction. As a result, a Josephson junction device called a Manhattan type is formed.

Note that, in the first embodiment, a case has been described as an example in which the superconducting film 14 is formed from obliquely above in the X-axis direction that is the extending direction of the opening 22 and the superconducting film 18 is formed from obliquely above in the Y-axis direction that is the extending direction of the opening 24. However, the present invention is not limited to this case, and the superconducting film 14 may be formed from obliquely above in a direction inclined within a range of ±5° in plan view from the X-axis direction that is the extending direction of the opening 22. The film formation of the superconducting film 18 may be performed from obliquely above in a direction inclined within a range of ±5° from plan view from the Y-axis direction that is the extending direction of the opening 24.

### [Second Embodiment]

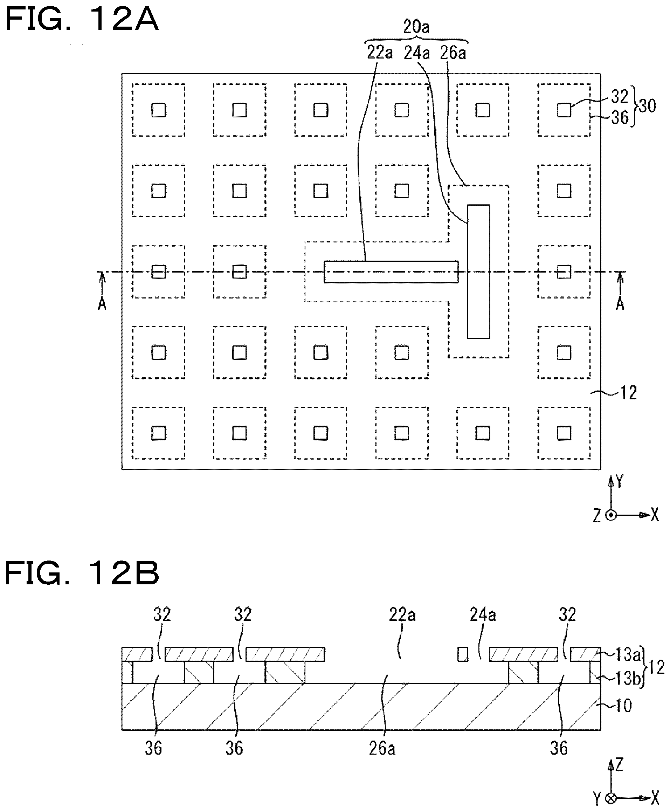

In a second embodiment, a method for manufacturing a Josephson junction device called a Dolan Bridge type will be described. FIGs. 12A to 16B are diagrams illustrating the method for manufacturing the Josephson junction device according to the second embodiment. FIGs. 12A, 13A, 14A, 15A, and 16A are plan views illustrating the method for manufacturing the Josephson junction device according to the second embodiment. FIGs. 12B, 13B, 14B, 15B, and 16B are cross-sectional views taken along A-A lines in FIGs. 12A, 13A, 14A, 15A, and 16A.

As in FIGs. 12A and 12B, a mask layer 12 having a mask pattern 20a and a mask pattern 30 is formed on a substrate 10. The mask pattern 20a has an opening 22a, an opening 24a, and a gap 26a. As in the first embodiment, the mask pattern 30 has an opening 32 and a gap 36, and the plurality of mask patterns 30 is provided around the mask pattern 20a at substantially constant intervals.

In the mask pattern 20a, the opening 22a extends in an X-axis direction, the opening 24a is separated from the opening 22a in the X-axis direction by an appropriate distance and extends in a Y-axis direction, and both openings are formed in an upper layer 13a. A width of the opening 22a and a width of the opening 24a are, for example, substantially the same, and are, for example, 100 nm to 300 nm. The gap 26a is positioned below the openings 22a and 24a and is formed in a lower layer 13b in a shape larger than the openings 22a and 24a in plan view. A portion of the upper layer 13a positioned between the openings 22a and 24a is formed to float above the gap 26a.

In the mask pattern 30, a length of the opening 32 in the X-axis direction is shorter than a length of the opening 24a in the X-axis direction, and a length of the opening 32 in the Y-axis direction is shorter than a length of the opening 22a in the Y-axis direction. The gap 36 is positioned below the opening 32 and is formed in the lower layer 13b in a shape larger than the opening 32 in plan view.

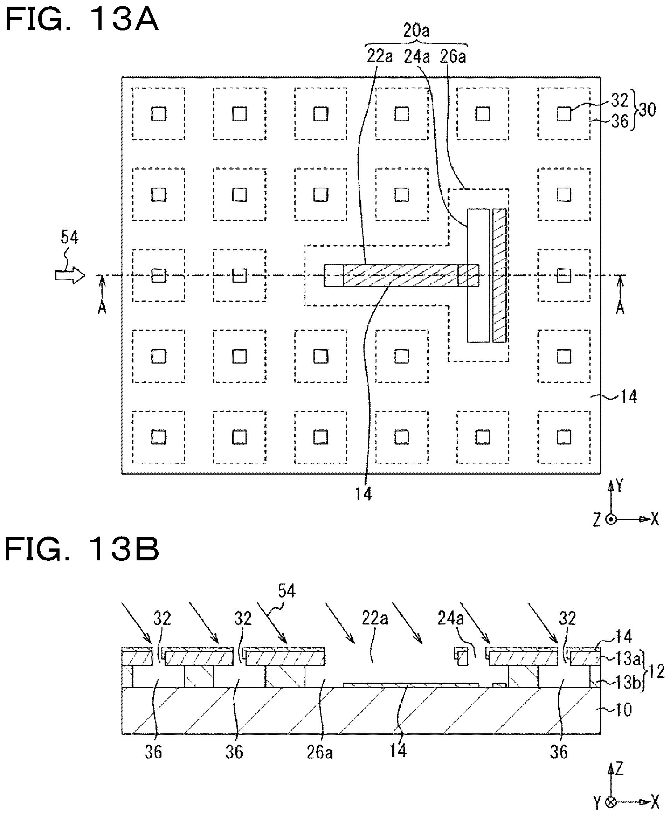

As in FIGs. 13A and 13B, the mask layer 12 is used as a mask, and a superconducting film 14 is formed above the substrate 10 by film formation from obliquely above in a -X direction, as indicated by an arrow 54. Since the superconducting film 14 is formed by the film formation from obliquely above in the -X direction, the superconducting film 14 formed in the gap 26a is formed to be shifted with respect to the openings 22a and 24a in a +X direction. Since the length of the opening 32 in the X-axis direction in the mask pattern 30 is shorter than the length of the opening 24a in the X-axis direction, the formation of the superconducting film 14 in the gap 36 is suppressed.

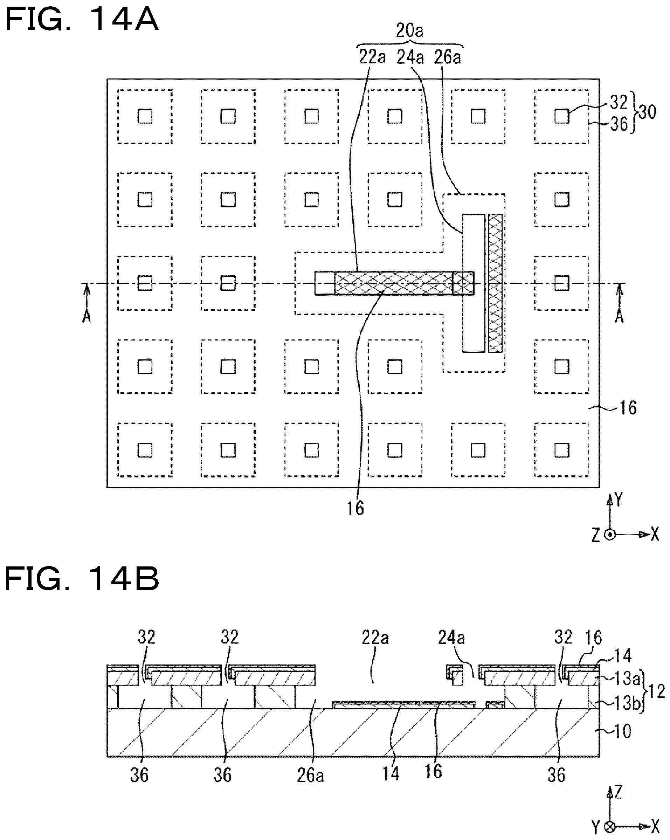

As in FIGs. 14A and 14B, while maintaining a vacuum state when the superconducting film 14 is formed, oxygen is introduced into a chamber to oxidize a surface of the superconducting film 14, and an insulating film 16 is formed at the surface of the superconducting film 14.

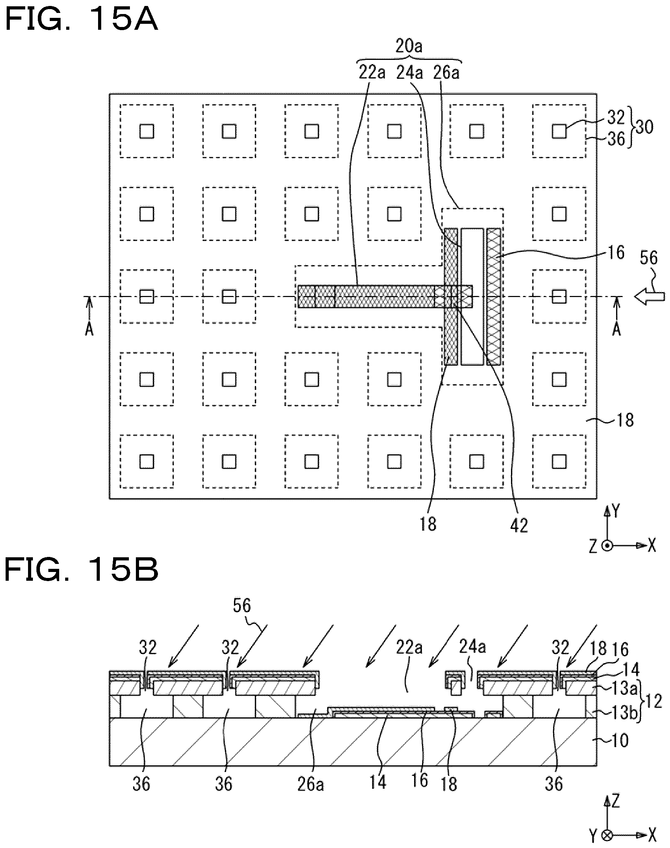

As in FIGs. 15A and 15B, the mask layer 12 is used as a mask, and a superconducting film 18 is formed above the substrate 10 by film formation from obliquely above in the +X direction, as indicated by an arrow 56. By appropriately setting the width of the opening 24a and/or a film formation angle from obliquely above, the superconducting film 18 extending in the Y-axis direction is formed in the gap 26a. Since the superconducting film 18 is formed by the film formation from obliquely above in the +X direction, the superconducting film 18 formed in the gap 26a is formed to be shifted with respect to the openings 22a and 24a in the -X direction. As a result, a region 42 is formed where the superconducting film 14 extending in the X-axis direction and the superconducting film 18 extending in the Y-axis direction overlap via the insulating film 16. Since the length of the opening 32 in the X-axis direction in the mask pattern 30 is shorter than the length of the opening 24a in the X-axis direction, the formation of the superconducting film 14 in the gap 36 is suppressed.

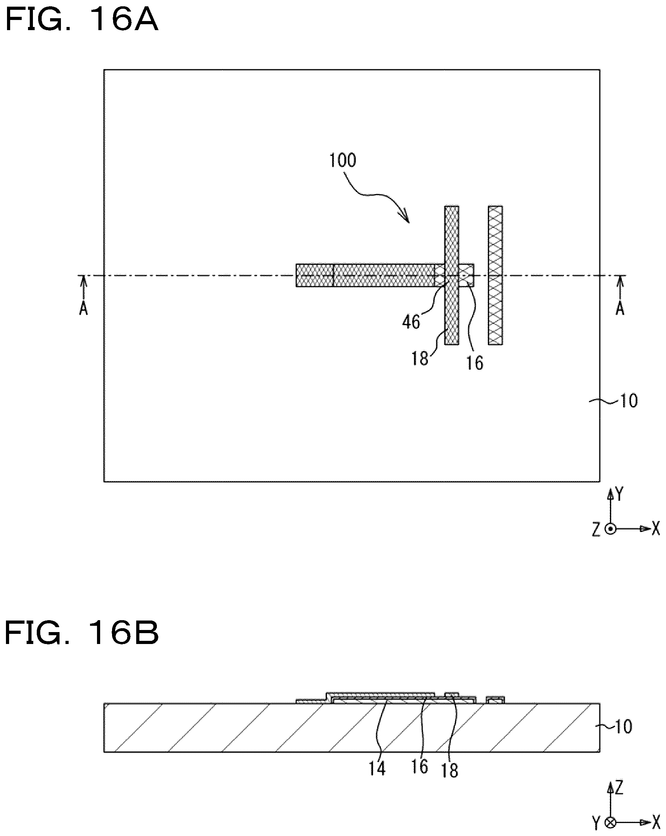

As in FIGs. 16A and 16B, the mask layer 12, and the superconducting film 14, the insulating film 16, and the superconducting film 18 formed above the mask layer 12 are removed by a lift-off method. In the mask layer 12, the openings 22a and 24a in the mask pattern 20a and the opening 32 in the mask pattern 30 are formed. Therefore, a peeling solution used for lift-off enters the mask layer 12 from the opening 32 in addition to the openings 22a and 24a. Therefore, a lift-off processing time is shortened as compared with a case where the opening 32 is not formed. A region where the superconducting film 14 extending in the X-axis direction and the superconducting film 18 extending in the Y-axis direction overlap via the insulating film 16 serves as a Josephson junction unit 46, and a Josephson junction device 100 is formed on the substrate 10.

According to the second embodiment, as in FIGs. 12A and 12B, the mask layer 12 including the mask pattern 20a (first mask pattern) and the mask pattern 30 (second mask pattern) is formed on the substrate 10. The mask pattern 20a has the opening 22a (first opening) extending in the X-axis direction and the opening 24a (second opening) extending in the Y-axis direction. The mask pattern 30 has the opening 32 shorter than the opening 22a in the Y-axis direction and shorter than the opening 24a in the X-axis direction. As in FIGs. 13A and 13B, by using the mask layer 12 as a mask and forming the film from obliquely above in the -X direction (first obliquely above direction) (first film formation), the superconducting film 14 is formed above the substrate 10 in the mask pattern 20a. As in FIGs. 14A and 14B, the insulating film 16 is formed on a surface of the superconducting film 14. As in FIGs. 15A and 15B, by using the mask layer 12 as a mask and forming the film from obliquely above in the +X direction (second obliquely above direction) (second film formation), the superconducting film 18 is formed in the mask pattern 20a. The superconducting film 18 is formed to have the region 42 overlapping the superconducting film 14 via the insulating film 16. As in FIGs. 16A and 16B, the mask layer 12 is removed by the lift-off. As a result, as in the first embodiment, the formation of the superconducting films 14 and 18 above the substrate 10 in the mask pattern 30 is suppressed. Therefore, a degree of freedom of a formation position of the mask pattern 30 increases, and the mask pattern 30 can be formed at a desired position. Since the peeling solution used for the lift-off enters the mask layer 12 from the opening 32 of the mask pattern 30 in addition to the openings 22 and 24 of the mask pattern 20, a peeling time of the mask layer 12 can be shortened.

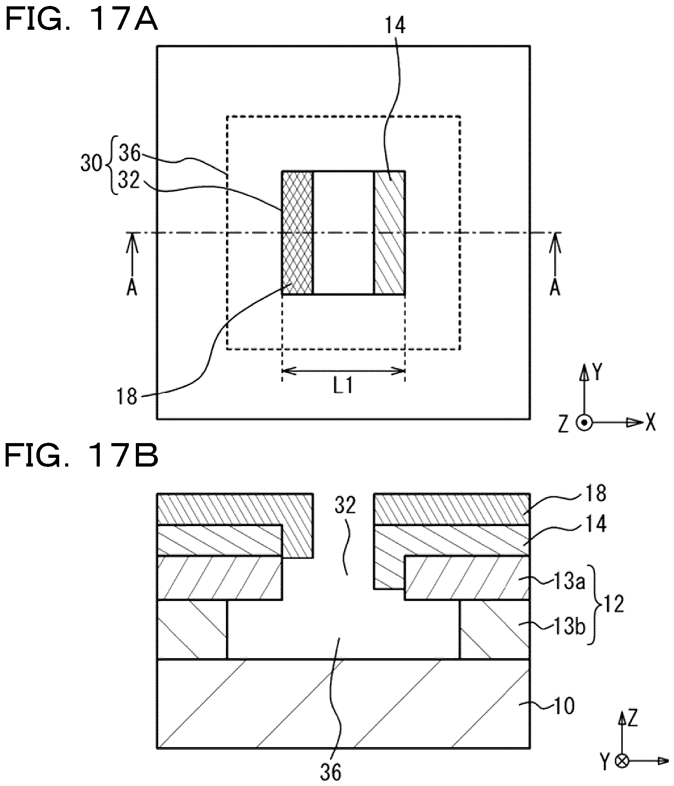

FIG. 17A is an enlarged plan view of vicinity of the mask pattern 30 in FIG. 15A, and FIG. 17B is a cross-sectional view taken along an A-A line in FIG. 17A. Note that, in FIGs. 17A and 17B, since the insulating film 16 is very thinner than the superconducting films 14 and 18, illustration is omitted here. As in FIGs. 17A and 17B, the superconducting film 14 is formed by film formation from obliquely above in the -X direction, and the superconducting film 18 is formed by film formation from obliquely above in the +X direction. Therefore, the superconducting films 14 and 18 are formed on side surfaces of the opening 32. Therefore, a length L1 of the opening 32 in the X-axis direction is set to be larger than a sum of a thickness of the superconducting film 14 and a thickness of the superconducting film 18, so that the peeling solution used for the lift-off can enter the mask layer 12 from the opening 32. From the viewpoint of causing the peeling solution to enter the mask layer 12 from the opening 32, the length L1 of the opening 32 in the X-axis direction is preferably equal to or more than 1.5 times of the sum of the thickness of the superconducting film 14 and the thickness of the superconducting film 18 and is more preferably equal to or more than 1.8 times, and still more preferably equal to or more than 2.0 times.

Furthermore, in the second embodiment, as in FIG. 12A, the mask layer 12 is formed that has the mask pattern 20a having the opening 22a extending in the X-axis direction and the opening 24a that is separated from the opening 22a in the X-axis direction and extends in the Y-axis direction. As in FIG. 13A, by the film formation from obliquely above in the -X direction, the superconducting film 14 is formed above the substrate 10 in the mask pattern 20a. As in FIG. 15A, by the film formation from obliquely above in the +X direction, the superconducting film 18 is formed above the substrate 10 in the mask pattern 20. As a result, a Josephson junction device called a Dolan Bridge type is formed.

Furthermore, in the second embodiment, as in the first embodiment, the superconducting film 14 is not formed on the substrate 10 in the mask pattern 30, and the superconducting film 18 is not formed on the substrate 10 in the mask pattern 30. As a result, a degree of freedom of the formation position of the mask pattern 30 increases. Furthermore, in the second embodiment, as in the first embodiment, the plurality of mask patterns 30 is provided around the mask pattern 20. As a result, the peeling solution used for the lift-off enters the mask layer 12 from the openings 32 of the plurality of mask patterns 30, and the peeling time of the mask layer 12 can be shortened. Furthermore, in the second embodiment, as in the first embodiment, the plurality of mask patterns 30 is provided so that the adjacent mask patterns 30 among the plurality of mask patterns 30 are arranged at constant intervals in the X-axis direction and the Y-axis direction without via the mask pattern 20. As a result, since the peeling solution used for the lift-off enters from the opening 32 across a wide range of the mask layer 12 without uneven distribution to a part of the mask layer 12, the peeling time of the mask layer 12 can be shortened.

Furthermore, in the second embodiment, as in the first embodiment, in the formation of the superconducting film 14, an incident angle of a film-forming material with respect to a normal line 11 of the substrate 10 in the film formation from obliquely above in the -X direction is set to θ1. A thickness of the upper layer 13a of the mask layer 12 is set to T. The length of the opening 32 in the X-axis direction that is a direction corresponding to obliquely above in the -X direction is set to L1. In this case, it is preferable that L1 ≤ T × tanθ1 be satisfied. In the formation of the superconducting film 18, an incident angle of the film-forming material with respect to the normal line 11 of the substrate 10 in the film formation from obliquely above in the +X direction is set to θ2. A thickness of the upper layer 13a of the mask layer 12 is set to T. The length of the opening 32 in the X-axis direction that is a direction corresponding to obliquely above in the +X direction is set to L1. In this case, it is preferable that L1 ≤ T × tanθ2 be satisfied. As a result, the formation of the superconducting films 14 and 18 above the substrate 10 in the mask pattern 30 is suppressed.

Note that, in the second embodiment, a case is described where the film formation of the superconducting films 14 and 18 is performed from obliquely above in the X-axis direction that is an extending direction of the opening 22, as an example. However, the present invention is not limited to this case, and the film formation of the superconducting films 14 and 18 may be performed from obliquely above in a direction inclined within a range of ±5° in plan view from the X-axis direction that is the extending direction of the opening 22.

Note that, in the first and second embodiments, a case has been described as an example where the openings 22 and 22a and the openings 24 and 24a extend in directions different from each other by 90°. However, a case may be used where the openings 22 and 22a and the openings 24 and 24a may extend in directions by an angle slightly different from 90° (for example, directions different by 80° to 100°). Furthermore, in the first and second embodiments, a case has been described as an example where the superconducting films 14 and 18 are formed using an oblique deposition method. However, the superconducting films 14 and 18 may be formed by a method other than the oblique deposition method. Furthermore, in the first and second embodiments, a case has been described where the superconducting films 14 and 18 are aluminum (Al) films. However, other cases may be used. For example, the superconducting films 14 and 18 may be a niobium (Nb) film, a niobium nitride (NbN) film, a tantalum (Ta) film, a tantalum nitride (TaN) film, or a titanium nitride (TiN) film. Although a case where the insulating film 16 is an oxide film of the superconducting film 14 is described as an example, other cases may be used.

### [Third Embodiment]

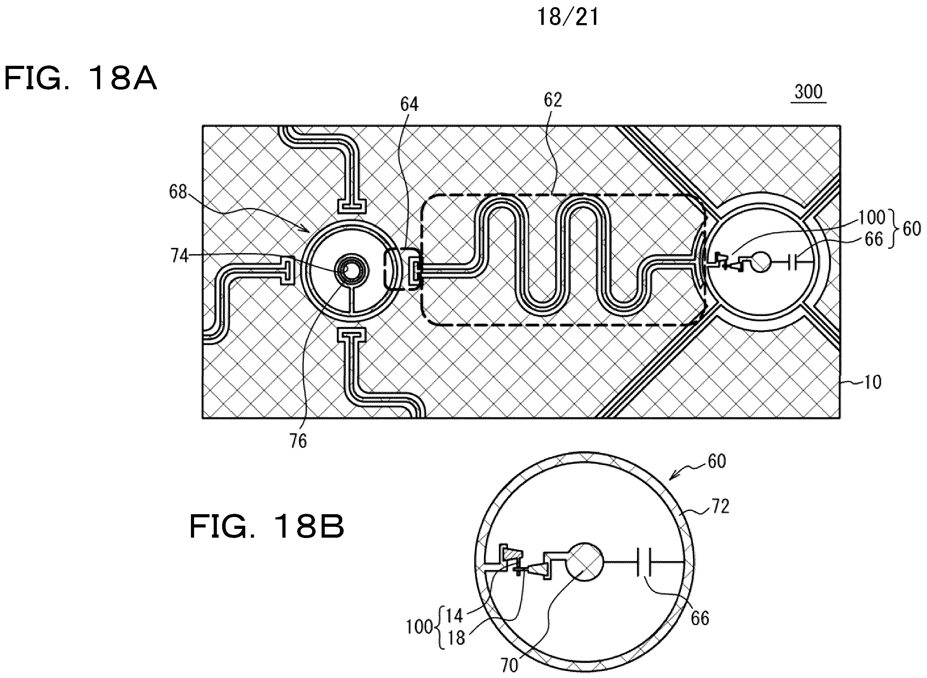

FIG. 18A is a plan view of a quantum bit device according to a third embodiment, and FIG. 18B is an enlarged view of a qubit in FIG. 18A. In FIGs. 18A and 18B, in order to clarity the figures, a metal film provided above a substrate 10 is hatched. As illustrated in FIGs. 18A and 18B, in a quantum bit device 300, a qubit 60, a resonator 62, and a filter 64 are provided above the substrate 10. The qubit 60 includes a Josephson junction device 100 coupled between a circular electrode 70 and an outer peripheral electrode 72, and a capacitor 66 formed by the circular electrode 70 and the outer peripheral electrode 72 facing each other. The Josephson junction device 100 is coupled between the circular electrode 70 and the outer peripheral electrode 72, by coupling a superconducting film 14 to the outer peripheral electrode 72 and coupling a superconducting film 18 to the circular electrode 70. In this way, the qubit 60 includes a transmon including the Josephson junction device 100 and the capacitor 66 coupled to the Josephson junction device 100 in parallel. The resonator 62 includes a coplanar line having a meandering structure, and one end is electrostatically coupled to the qubit 60. Another end of the resonator 62 is coupled to a reading unit 68 via the filter 64. The reading unit 68 includes a through-hole 74 that passes through the substrate 10 and an electrode 76 provided at an inner surface of the through-hole 74.

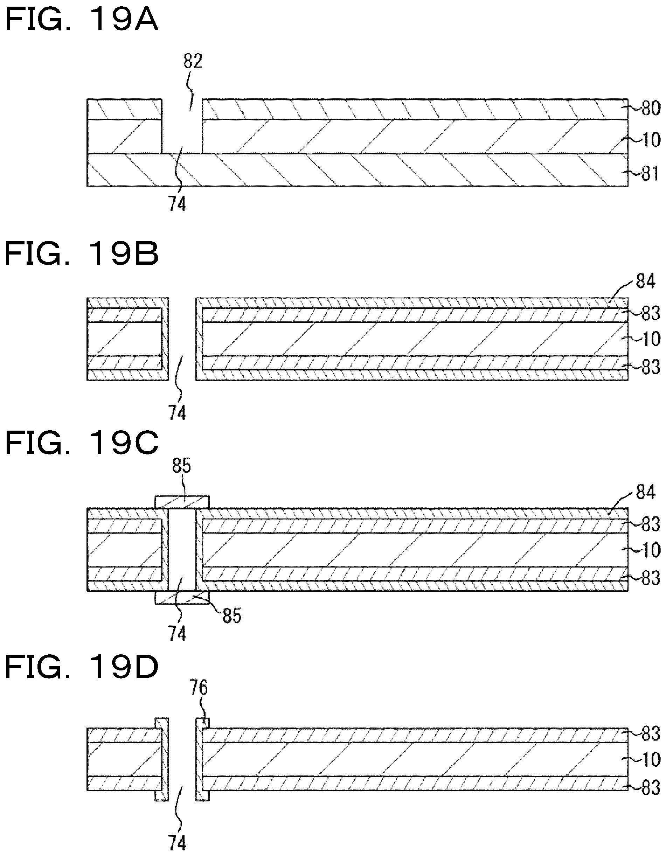

FIGs. 19A to 21C are cross-sectional views illustrating a method for manufacturing the quantum bit device according to the third embodiment. As illustrated in FIG. 19A, after a mask layer 80 including, for example, a resist is formed on the substrate 10, the substrate 10 is bonded to a substrate 81. An opening 82 is formed in the mask layer 80. The substrate 10 is etched by using the mask layer 80 as a mask, and the through-hole 74 that passes through the substrate 10 is formed. For example, dry etching is used as the etching. The substrate 81 is used to cool the substrate 10 and suppress a temperature increase of the substrate 10 and/or for adsorption at the time of etching processing, in the etching for forming the through-hole 74 in the substrate 10.

As in FIG. 19B, after the mask layer 80 and the substrate 81 are removed, a superconducting film 83 is formed, for example, using a sputtering method, on an upper surface and a lower surface of the substrate 10. The superconducting film 83 is, for example, a titanium nitride film, and a thickness is about 100 nm. Thereafter, a superconducting film 84 is formed by an oblique vacuum deposition method, above the upper surface and below the lower surface of the substrate 10. The superconducting film 84 is formed on the inner surface of the through-hole 74. The superconducting film 84 is, for example, an aluminum film, and a thickness is 300 nm.

As illustrated in FIG. 19C, after a dry film resist is laminated above the upper surface and below the lower surface of the substrate 10, the dry film resist is patterned, and a mask layer 85 covering the through-hole 74 is formed.

As in FIG. 19D, the mask layer 85 is used as a mask, and the superconducting film 84 is etched. For example, wet etching is used as the etching. Thereafter, the mask layer 85 is removed. As a result, the electrode 76 including the superconducting film 84 is formed on the inner surface of the through-hole 74.

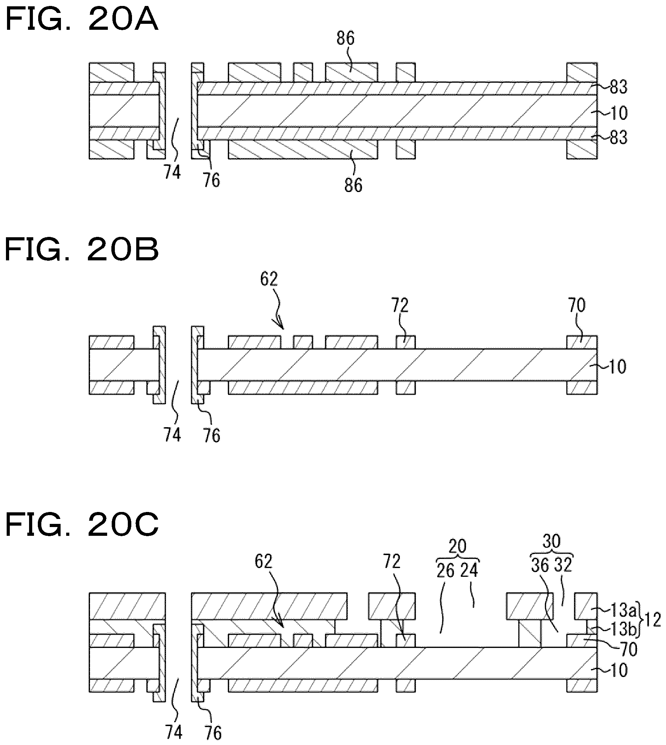

As in FIG. 20A, after resist films are formed above the upper surface and below the lower surface of the substrate 10, the resist film is patterned so as to form a mask layer 86.

As in FIG. 20B, the mask layer 86 is used as a mask, and the superconducting film 83 is etched. For example, dry etching is used as the etching. Thereafter, the mask layer 86 is removed. As a result, the resonator 62 including the coplanar line and the circular electrode 70 and the outer peripheral electrode 72 included in the qubit 60 are formed by the superconducting film 83. Furthermore, although not illustrated, the filter 64 or the like is formed by the superconducting film 83.

As in FIG. 20C, a mask layer 12 including an upper layer 13a and a lower layer 13b is formed above the substrate 10. In the mask layer 12, a mask pattern 20 having an opening 24 and a gap 26 and a mask pattern 30 having an opening 32 and a gap 36 are formed. Note that, although the mask pattern 20 has the opening 22 as in FIG. 1A or the like, the opening 22 is not illustrated in FIG. 20C.

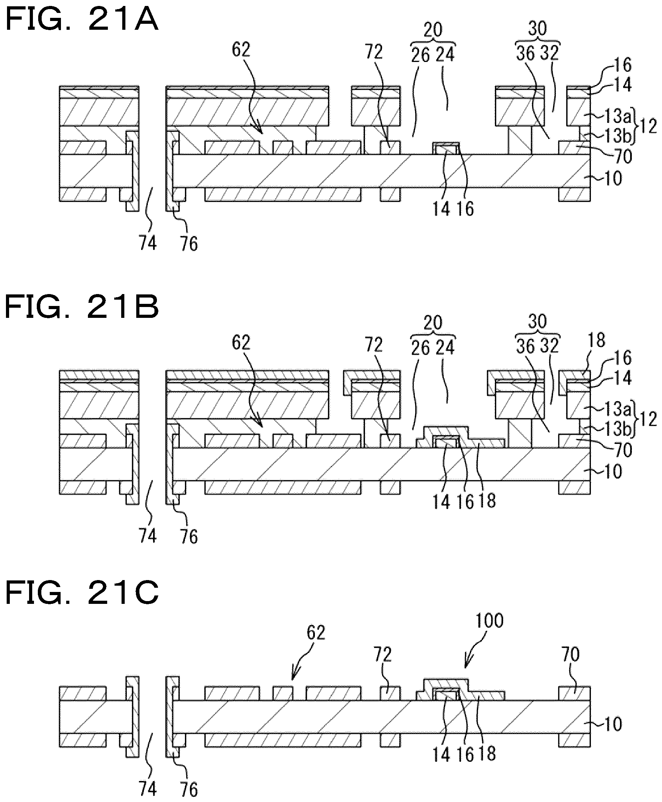

As in FIG. 21A, the mask layer 12 is used as a mask, and the superconducting film 14 is formed above the substrate 10 by film formation from obliquely above in an extending direction of the opening 22. As a result, as described in the first embodiment, the superconducting film 14 extending in the extending direction of the opening 22 is formed in the gap 26. Since the opening 32 is small, the formation of the superconducting film 14 in the gap 36 is suppressed. Thereafter, while maintaining a vacuum state when the superconducting film 14 is formed, oxygen is introduced into a chamber to oxidize a surface of the superconducting film 14, and an insulating film 16 is formed at the surface of the superconducting film 14.

As in FIG. 21B, the mask layer 12 is used as a mask, and the superconducting film 18 is formed above the substrate 10 by film formation from obliquely above in an extending direction of the opening 24. As a result, as described in the first embodiment, the superconducting film 18 extending in the extending direction of the opening 24 is formed in the gap 26. Since the opening 32 is small, the formation of the superconducting film 18 in the gap 36 is suppressed.

As in FIG. 21C, the mask layer 12, and the superconducting film 14, the insulating film 16, and the superconducting film 18 formed above the mask layer 12 are removed by a lift-off method. In the mask layer 12, the openings 22 and 24 in the mask pattern 20 and the opening 32 in the mask pattern 30 are formed. Therefore, a peeling solution used for lift-off enters from the opening 32 in addition to the openings 22 and 24, and the mask layer 12 is removed. On the substrate 10, the Josephson junction device 100 in which the superconducting films 14 and 18 overlap via the insulating film 16 is formed.

According to the third embodiment, the Josephson junction device 100 included in the qubit 60 coupled to the resonator 62 and the filter 64 is formed by the method described in the first embodiment. As a result, a peeling time of the mask layer 12 used to form the Josephson junction device 100 can be shortened.

Note that, in the third embodiment, the Josephson junction device 100 is not limited to be formed by the method described in the first embodiment and may be formed by the method described in the second embodiment.

While the embodiments of the present invention have been described in detail above, the present invention is not limited to such specific embodiments, and various modifications and alternations may be made within the scope of the gist of the present invention described in the claims.

## Claims

1. A method for manufacturing a Josephson junction device comprising:
a process of forming a mask layer, on a substrate, that includes a first mask pattern that has a first opening that extends in a first direction and a second opening that extends in a second direction that intersects with the first direction and a second mask pattern that has a third opening that is shorter than the second opening in the first direction and is shorter than the first opening in the second direction;
a process of forming a first superconducting film above the substrate in the first mask pattern, by first film formation from obliquely above the substrate, as using the mask layer as a mask;
a process of forming an insulating film above a surface of the first superconducting film;
a process of forming a second superconducting film that has a region that overlaps the first superconducting film via the insulating film in the first mask pattern, by second film formation from obliquely above the substrate, as using the mask layer as a mask; and
a process of removing the mask layer by lift-off.

2. The method for manufacturing the Josephson junction device according to claim **1,** wherein
in the process of forming the first superconducting film, the first superconducting film is not formed on the substrate in the second mask pattern, and
in the process of forming the second superconducting film, the second superconducting film is not formed on the substrate in the second mask pattern.

3. The method for manufacturing the Josephson junction device according to claim 1 or **2,** wherein the process of forming the mask layer forms the mask layer in which a plurality of the second mask patterns is provided around the first mask pattern.

4. The method for manufacturing the Josephson junction device according to claim **3,** wherein the process of forming the mask layer forms the mask layer that includes the plurality of second mask patterns of which the adjacent second mask patterns are arranged at constant intervals without via the first mask pattern in the first direction and the second direction, among the plurality of second mask patterns.

5. The method for manufacturing the Josephson junction device according to claim 1 or **2,** wherein
the process of forming the mask layer forms the mask layer that includes an upper layer and a lower layer and in which the first mask pattern has the first opening and the second opening formed in the upper layer and a first gap that is formed in the lower layer below the first opening and the second opening and is larger than the first opening and the second opening in plan view and the second mask pattern has the third opening formed in the upper layer and a second gap that is formed in the lower layer below the third opening and is larger than the third opening in plan view,
in a case where an incident angle of a film-forming material with respect to a normal line of the substrate in the first film formation is set to θ1, a length of the third opening in a direction that corresponds to the obliquely above in the first film formation is set to L1, and a thickness of the upper layer is set to T, L1 ≤ T × tanθ1 is satisfied, and
in a case where an incident angle of a film-forming material with respect to a normal line of the substrate in the second film formation is set to θ2, a length of the third opening in a direction that corresponds to the obliquely above in the second film formation is set to L2, and the thickness of the upper layer is set to **T,** L2 ≤ T × tanθ2 is satisfied.

6. The method for manufacturing the Josephson junction device according to claim 1 or **2,** wherein
the process of forming the mask layer forms the mask layer that includes the first mask pattern in which the first opening intersects with the second opening,
the process of forming the first superconducting film forms the first superconducting film by the first film formation from obliquely above the substrate in the first direction, and
the process of forming the second superconducting film forms the second superconducting film by the second film formation from obliquely above the substrate in the second direction.

7. The method for manufacturing the Josephson junction device according to claim **6,** wherein
the process of forming the mask layer forms the mask layer in which a length of the third opening in the first direction is larger than a thickness of the first superconducting film and a length of the third opening in the second direction is larger than a thickness of the second superconducting film.

8. The method for manufacturing the Josephson junction device according to claim 1 or 2, wherein
the process of forming the mask layer forms the mask layer that includes the first mask pattern in which the second opening is separated from the first opening in the first direction,
the process of forming the first superconducting film forms the first superconducting film by the first film formation from obliquely above the substrate in the first direction, and
the process of forming the second superconducting film forms the second superconducting film by the second film formation from obliquely above the substrate that is opposite to obliquely above the substrate in the first film formation, with respect to the substrate.

9. The method for manufacturing the Josephson junction device according to claim 8, wherein
the process of forming the mask layer forms the mask layer in which a length of the third opening in the first direction is larger than a sum of a thickness of the first superconducting film and a thickness of the second superconducting film.

10. The method for manufacturing the Josephson junction device according to claim 1 or 2, wherein
the process of forming the first superconducting film forms the first superconducting film by oblique vapor deposition, and
the process of forming the second superconducting film forms the second superconducting film by oblique vapor deposition.

11. A method for manufacturing a quantum bit device comprising:
a process of forming a Josephson junction device;
a process of forming a capacitor coupled to the Josephson junction device in parallel; and
a process of forming a resonator and a filter coupled to a qubit that includes the Josephson junction device and the capacitor, wherein
the process of forming the Josephson junction device includes
a process of forming a mask layer, on a substrate, that includes a first mask pattern that has a first opening that extends in a first direction and a second opening that extends in a second direction that intersects with the first direction and a second mask pattern that has a third opening that is shorter than the second opening in the first direction and is shorter than the first opening in the second direction,
a process of forming a first superconducting film above the substrate in the first mask pattern, by first film formation from obliquely above the substrate, as using the mask layer as a mask,
a process of forming an insulating film above a surface of the first superconducting film,
a process of forming a second superconducting film that has a region that overlaps the first superconducting film via the insulating film in the first mask pattern, by second film formation from obliquely above the substrate, as using the mask layer as a mask, and
a process of removing the mask layer by lift-off.
